Europäisches Patentamt

European Patent Office

Office européen des brevets

(19)

(11) Veröffentlichungsnummer: **0 196 032**
A2

(12) ## EUROPÄISCHE PATENTANMELDUNG

(21) Anmeldenummer: 86103934.5

(22) Anmeldetag: 22.03.86

(51) Int. Cl.⁴: **H 05 K  3/36,** H 05 K  7/02

(30) Priorität: 26.03.85  DE 3510820

(43) Veröffentlichungstag der Anmeldung: 01.10.86
Patentblatt 86/40

(84) Benannte Vertragsstaaten: **FR GB IT**

(71) Anmelder: **Erhardt &-Leimer GmbH, Leitershofer Strasse 80, D-8900 Augsburg 1 (DE)**

(72) Erfinder: **Gröninger, Alois, Ohnsorgstrasse 18a, D-8900 Augsburg (DE)**

(74) Vertreter: **Sasse, Volker, Dipl.-Ing., Parreutstrasse 27, D-8070 Ingolstadt (DE)**

(54) **Vorrichtung zur elektronischen Steuerung und Regelung von Maschinen.**

(57) Die Leiterplatten (1) einer Vorrichtung zur elektronischen Steuerung und Regelung weisen einen Analogteil (4) und einen Digitalteil (5) auf. Über einen Analog-Anschluß (6) für den Analogteil (4) und einen Digital-Anschluß (7) für den Digitalteil (5) sind die Leiterplatten (1) mit einem Analog-Leitungsbündel (2) sowie einem Digital-Leitungsbündel (3) elektrisch verbunden. Das Analog-Leitungsbündel (2) enthält alle für den Anschluß der Analogteile (4) erforderlichen Leitungen, wie Stromversorgungsleitung (8), Masseleitung (9), Signalleitung (10) und Steuerleitungen (11, 12). Im Digital-Leitungsbündel (3) sind alle für den Anschluß der Digitalteile (5) notwendigen Leitungen zusammengefaßt. Hierdurch wird ein einfaches und flexibles System von Verbindungsleitungen für den Anschluß auch der Analogteile (4) der Leiterplatten (1) geschaffen.

EP 0 196 032 A2

Die Erfindung betrifft eine Vorrichtung zur elektronischen Steuerung und Regelung von Maschinen und Anlagen mit Leiterplatten, die einen Analogteil mit analogen Schaltungen und einen Digitalteil mit Bauelementen zur digitalen Signalverarbeitung aufweisen, und mit einem Gehäuse, in dem die Leiterplatten montiert sind.

Die einzelnen, für eine solche Steuer- und Regeleinrichtung erforderlichen elektronischen Bauelemente werden üblicherweise auf mehreren, mit gedruckten Leiterbahnen versehenen Leiterplatten angeordnet. Die fertig bestückten Leiterplatten werden gemeinsam in ein von der zu steuernden oder regelnden Maschine oder Anlage räumlich getrenntes Gehäuse montiert und dort elektrisch zusammengeschaltet. Bei modernen, leistungsfähigen Steuer- und Regeleinrichtungen werden die von der angeschlossenen Maschine oder Anlage kommenden elektrischen Meßwerte in digitale Signale umgewandelt; diese werden - beispielsweise in einem Mikrorechner - digital verarbeitet. Die so gewonnenen, digitalen Ausgangssignale müssen in ein analoges Signal rückgewandelt werden, damit sie nach entsprechender Verstärkung und ggfs. über eine Ansteuerungsschaltung die Maschine oder Anlage steuern bzw. regeln können. Die Leiterplatten enthalten daher sowohl analog arbeitende Schaltungen wie auch Bauelemente für die digitale Signalverarbeitung. An den Schnittstellen zwischen analogen und digitalen Schaltungsteilen sind Analog/Digital-Wandler erforderlich. Die digitalen Baugruppen der einzelnen Leiterplatten müssen elektrisch miteinander verbunden werden; außerdem ist der Anschluß an eine Stromversorgung erforderlich. Die Eingänge der Analogteile der Leiterplatten sind mit den Meßwertaufnahmen und deren Ausgänge mit den Elektromotoren oder Stellgliedern der Maschine bzw. Anlage, elektrisch zu verbinden; Stromversorgung und externe Meß- und Prüfgeräte erfordern weitere Anschlußleitungen. Die Herstellung dieser Vielzahl von erforderlichen elektrischen Verbindungen zu den Leiterplatten erfolgte bisher über einzelne Kabelanschlüsse auf den Leiterplatten. Lediglich bei der Zusammenschaltung der Digitalteile mehrerer Leiterplatten ist die Verwendung einer genormten Daten-Sammelleitung, einem sogenannten Bus, üblich.

Die Verwendung einer Vielzahl einzelner Anschlüsse für die übrigen elektrischen Verbindungen ist umständlich und störanfällig. Außerdem ist der Austausch einer defekten Leiterplatte nur nach Abtrennung sämtlicher Anschlußleitungen möglich, was die Wartung einer derartigen Steuer- und Regeleinrichtung erschwert.

Aufgabe vorliegender Erfindung ist deshalb die Schaffung einer elektronischen Steuer- und Regeleinrichtung, bei der die elektrischen Verbindungen vor- und zu den mit elektronischen Bauelementen bestückten Leiterplatten schnell, einfach und störungssicher erfolgen.

Bei der Lösung dieser Aufgabe wird von einer Vorrichtung zur elektronischen Steuerung und Regelung von Maschinen und Anlagen der eingangs erwähnten Art ausgegangen, und gelöst wird die Aufgabe dadurch, daß die Leiterplatten jeweils mit einem Analog-Anschluß für den Analogteil und einem Digital-Anschluß für den Dititalteil versehen sind, daß ein Analog-Leitungsbündel sowie ein Digital-Leitungsbündel vorgesehen sind, und daß die Analogteile über ihre Analog-Anschlüsse mit dem Analog-Leitungsbündel und die Digitalteile über ihre Digital-Anschlüsse mit dem Digital-Leitungsbündel elektrisch verbunden sind. Alle für den Anschluß der Analogteile der Leiterplatten erforderlichen elektrischen Leitungen sind so im Analog-Leitungsbündel, entsprechend einem sogenannten Analog-Bus, zusammengefaßt. Ebenso vereinigt das Digital-Leitungsbündel alle notwendigen Verbindungsleitungen von und zu den Digitalteilen mehrerer Leiterplatten. Hierdurch wird ein übersichtlicher Geräteaufbau erreicht und das Auftreten von Störungen infolge unkontrollierter Leitungsführung wirksam verhindert. Über die Analog- und Digital-Anschlüsse lassen sich die Leiterplatten schnell und einfach anschließen. Ebenso ist ein späterer Austausch einer Leiterplatte leicht möglich. Durch das einheitliche, konfektionierte elektrische Verbindungssystem wird eine hohe Flexibilität bei der Anpassung der Steuer- und Regelvorrichtung an unterschiedliche Aufgaben erreicht.

In vorteilhafter Ausgestaltung der Erfindung werden die Analogteile

der Leiterplatten über Stromzuführungsleitungen des Analog-Leitungsbündels mit Strom versorgt. Die Integrierung der Stromzuführung in
das Analog-Leitungsbündel führt zu einer weiteren Vereinfachung des
elektrischen Aufbaus infolge des Wegfalls besonderer Anschlüsse für
die Stromversorgung.

Es ist zweckmäßig, die Digitalteile der Leiterplatten über Stromzuführungsleitungen des Digital-Leitungsbündels mit Strom zu versorgen und auf diese Weise die Zahl der notwendigen Anschlußelemente
weiter zu verringern.

In bevorzugter Ausführungsform enthält das Digital-Leitungsbündel
einen Daten-Bus, über den die Digitalteile mehrerer Leiterplatten in
Kommunikation stehen.

Bei einer besonders bevorzugten Ausführungsform der Erfindung enthält das Analog-Leitungsbündel zudem wenigstens eine Signalleitung,
auf der Meßwerte der zu steuernden oder regelnden Maschine oder
Anlage anliegen. Enthält das Analog-Leitungsbündel außerdem auch
wenigstens eine Steuerleitung, die über den Analog-Anschluß mit
dem Ausgang des Analogteils einer der Leiterplatten verbunden ist,
sind alle notwendigen elektrischen Verbindungsleitungen zwischen
Maschine bzw. Anlage und Regel- und Steuereinrichtung in das Analog-Leitungsbündel integriert. Damit stehen alle wesentlichen analogen Signale und Spannungen an jeder Stelle des Analog-Leitungsbündels zur Verfügung und können über einen Analog-Anschluß abgegriffen werden. Hierdurch ist es möglich, an beliebiger Stelle Leiterplatten, aber auch Meß- und Prüfgeräte anzuschließen. Auch können Leiterplatten leicht gegen anders bestückte Leiterplatten ausgetauscht werden, ohne daß es einer Änderung im Verdrahtungssystem
der Steuer- und Regelvorrichtung bedarf. Mit der Erfindung ist somit ein einfaches und höchst flexibles System von elektrischen Verbindungsleitungen für den Anschluß auch der Analogteile der Leiterplatten geschaffen worden, das in der Wirkung dem in der Digitaltechnik verwendeten Bus-System entspricht.

In weiterer, vorteilhafter Ausgestaltung der Erfindung sind die elektrischen Verbindungen zwischen den Analog-Anschlüssen und dem Analog-Leitungsbündel sowie zwischen den Digital-Anschlüssen und dem Digital-Leitungsbündel mechanisch lösbar. Das Auswechseln von Leiterplatten ist damit besonders einfach möglich.

Zweckmäßig sind die Analog-Anschlüsse und die Digital-Anschlüsse als auf den Leiterplatten befestigte Steckkontakte ausgebildet und das Analog-Leitungsbündel und das Digital-Leitungsbündel mit dazu passenden Steckerleisten versehen.

Bei einer besonders vorteilhaften Ausführung der Erfindung sind die Steckerleisten an der Rückseite des Gehäuses oder auf einer Basis-Leiterplatte paarweise so angebracht, daß die Leiterplatten mit ihren Steckkontakten in die Steckerleisten der Basis-Leiterplatte eingesteckt werden können. Dadurch lassen sich die so als Steckkarten ausgebildeten Leiterplatten mit einem Griff in das Gehäuse einsetzen und auch wieder aus diesem entfernen.

Eine besonders übersichtliche und störungssichere Leitungsführung ergibt sich, wenn die Steckerleisten an der Rückseite des Gehäuses paarweise vertikal übereinander angebracht sind. Diese Anordnung gestattet es auch, die Steckkontakte auf den Leiterplatten platzsparend an deren hinteren Kanten anzubringen.

Ein Ausführungsbeispiel der Erfindung wird nachstehend anhand der Zeichnungen erläutert.

Es zeigt:

Fig. 1    Eine erfindungsgemäße elektronische Steuerungs- und Regelvorrichtung, die an eine Maschine angeschlossen ist, in einem vereinfachten Prinzipbild und

Fig. 2    schematisch die Anordnung der Steckerleisten der Analog- und Digital-Leitungsbündel auf einer Basis-Leiterplatte einer erfindungsgemäßen Steuerungs- und Regelvorrichtung.

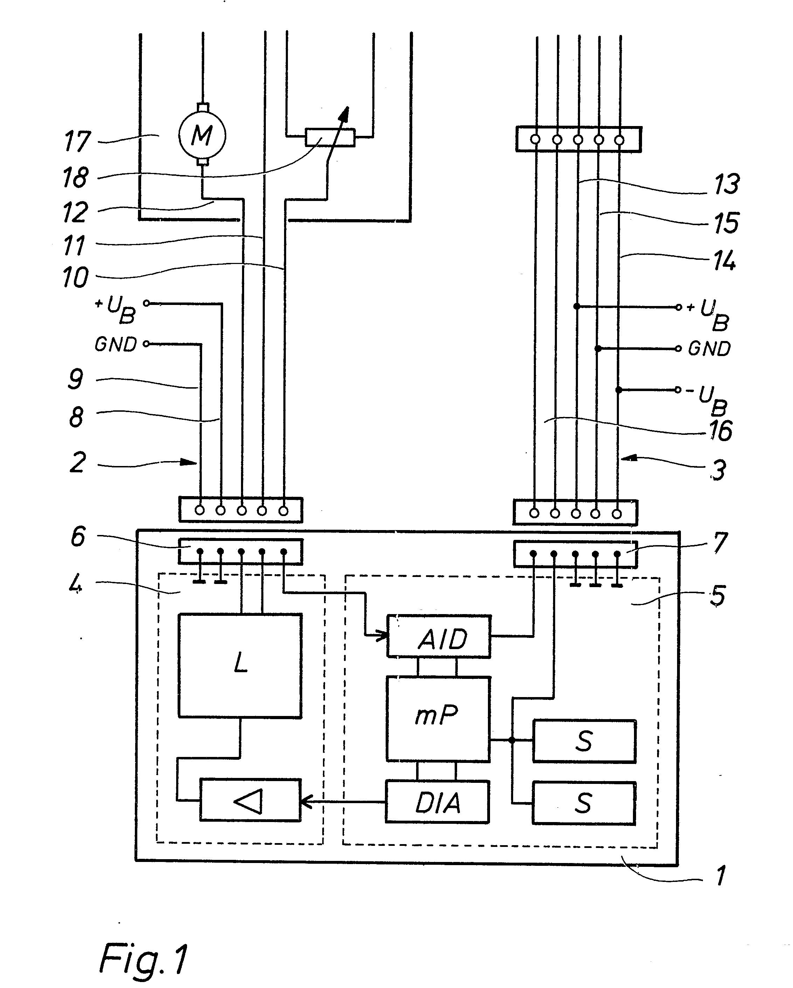

Die in Fig. 1 schematisch dargestellte Vorrichtung zur elektronischen Steuerung und Regelung weist eine Leiterplatte 1, die in ein
- nicht dargestelltes - Gehäuse montiert ist, ein Analog-Leitungsbündel 2 und ein Digital-Leitungsbündel 3 auf. Auf der Leiterplatte
1 befindet sich ein Analogteil 4 mit analog arbeitenden elektronischen Bauelementen sowie ein Bauelement zur digitalen Signalverarbeitung umfassender Digitalteil 5. Der Analogteil 4 ist über seinen
als Mehrfachstecker ausgebildeten Analog-Anschluß 6 mit dem Analog-
Leitungsbündel 2 elektrisch verbunden. Der Digitalteil 5 ist über
seinen Digital-Anschluß 7 an das Digital-Leitungsbündel 3 angeschlossen. Das Analog-Leitungsbündel 2 enthält eine Stromversorgungsleitung 8, eine Masseleitung 9, eine Signalleitung 10 und zwei
Steuerleitungen 11 und 12. Im Digital-Leitungsbündel 3 sind zwei
Stromversorgungsleitungen 13 und 14, eine Masseleitung 15 und ein
aus zwei weiteren, parallelen Leitungen bestehender Daten-Bus 16
integriert. Eine zu steuernde bzw. zu regelnde Maschine 17 ist über
die Signalleitung 10 und die beiden Steuerleitungen 11, 12 an dem
Analoganschluß 6 der Leiterplatte 1 angeschlossen. Ein Ist-Wert-Geber 18 liefert ein analoges Signal, das über den Analog-Anschluß
6 an den Eingang eines zum Digitalteil 3 der Leiterplatte 1 gehörenden Analog/Digitalwandlers A/D gelangt wo es in ein digitales Signal umgewandelt wird. Die Weiterverarbeitung dieses Digitalsignals
findet in einem Mikroprozessor mP statt, an den zwei Speicher S angeschlossen sind. Nach Rückwandlung mittels eines Digital-Analogwandlers D/A wird das so gewonnene analoge Steuersignal verstärkt
und einer Leistungselektronik L zugeführt, deren Ausgänge über die
beiden Steuerleitungen 11, 12 mit der Maschine 17 verbunden sind.
Auf diese Weise wird ein Stellmotor M der Maschine 17 in Abhängigkeit von dem Signal des Ist-Wert-Gebers 18 gesteuert. Alle für die
Steuerung und Regelung der Maschine 17 erforderlichen analogen
Signale und Spannungen stehen an dem Analog-Anschluß 6 zur Verfügung.

Über das Analog-Leitungsbündel 2 und das Digital-Leitungsbündel
3 ist die Leiterplatte 1 mit anderen - nicht dargestellten - Leiter-

*platten verbunden.*

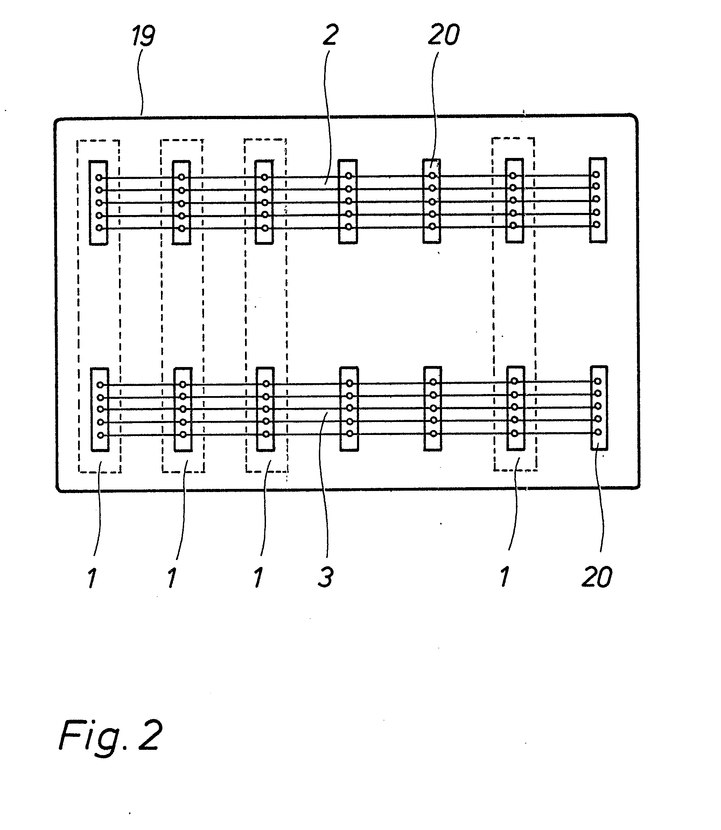

*Fig. 2 veranschaulicht beispielsweise die räumliche Anordnung der Leiterplatten 1 auf einer Basis-Leiterplatte 19. An der als Basis-Leiterplatte 19 ausgebildeten Rückseite des Gehäuses sind Steckerleisten 20 paarweise vertikal übereinander angeordnet. Das Analog-Leitungsbündel 2 und das Digital-Leitungsbündel 3 verlaufen quer zu den Steckerleisten 20. Die Leiterplatten 1 sind mit ihren an der hinteren Kante angeordneten, als Mehrfachstecker (nicht dargestellt) ausgebildeten Analog-Anschlüssen 6 und Digital-Anschlüssen 7 (vergleiche Figur 1) in die Steckerleisten 20 eingesteckt.*

## Verzeichnis der verwendeten Bezugszeichen

1 Leiterplatte

2 Analog-Leitungsbündel

3 Digital-Leitungsbündel

4 Analogteil (von 1)

5 Digitalteil (von 1)

6 Analog-Anschluß (auf 1)

7 Digital-Anschluß (auf 1)

8 Stromversorgungsleitung (in 2)

9 Masseleitung (in 2)

10 Signalleitung (in 2)

11 Steuerleitung (in 2)

12 Steuerleitung (in 2)

13 Stromversorgungsleitung (in 3)

14 Stromversorgungsleitung (in 3)

15 Masseleitung (in 3)

16 Daten-Bus (in 3)

17 Maschine

18 Ist-Wert-Geber (in 17)

19 Gehäuse

20 Steckerleisten

A/D Analog/Digital-Wandler

D/A Digital/Analog-Wandler

mP Mikroprozessor

S Speicher

L Leistungselektronik

**0196032**
12.03.1986
Le-69aus
S/M

*Vorrichtung zur elektronischen Steuerung und Regelung von*
*Maschinen*

---

## *Patentansprüche*

1. *Vorrichtung zur elektronischen Steuerung und Regelung von Ma-*
*schinen und Anlagen mit Leiterplatten, die einen Analogteil mit*
*analogen Schaltungen und einen Digitalteil mit Bauelementen zur di-*
*gitalen Signalverarbeitung aufweisen, und mit einem Gehäuse, in*
*dem die Leiterplatten montiert sind, dadurch gekennzeichnet, daß*
*die Leiterplatten (1) jeweils mit einem Analog-Anschluß (6) für den*
*Analogteil (4) und einen Digital-Anschluß (7) für den Digitalteil (5)*
*versehen sind, daß ein Analog-Leitungsbündel (2) sowie ein Digital-*
*Leitungsbündel (3) vorgesehen sind, und daß die Analogteile (4)*
*über ihre Analog-Anschlüsse (6) mit dem Analog-Leitungsbündel (2)*
*und die Digitalteile (5) über ihre Digital-Anschlüsse (7) mit dem*
*Digital-Leitungsbündel (3) elektrisch verbunden sind.*

2. *Vorrichtung nach Anspruch 1, dadurch gekennzeichnet, daß die*
*Analogteile (4) der Leiterplatten (1) über Stromzuführungsleitungen*
*(8, 9) des Analog-Leitungsbündels (2) mit Strom versorgt werden.*

3. Vorrichtung nach Anspruch 1 oder 2, dadurch gekennzeichnet, daß die Digitalteile (5) der Leiterplatten (1) über Stromzuführungsleitungen (13, 14, 15) des Digital-Leitungsbündels (3) mit Strom versorgt werden.

4. Vorrichtung nach einem der Ansprüche 1 bis 3, dadurch gekennzeichnet, daß das Digital-Leitungsbündel (3) einen Daten-Bus (16) enthält.

5. Vorrichtung nach Anspruch 1 oder 2, dadurch gekennzeichnet, daß das Analog-Leitungsbündel (2) wenigstens eine Signalleitung (10) enthält, auf der Meßwerte der zu steuernden oder zu regelnden Maschine oder Anlage (17) anliegen.

6. Vorrichtung nach wenigstens einem der Ansprüche 1, 2, 5, dadurch gekennzeichnet, daß das Analog-Leitungsbündel (2) wenigstens eine Steuerleitung (11, 12) enthält, die über den Analog-Anschluß (6) mit dem Ausgang des Analogteils (4) einer der Leiterplatten (1) verbunden ist.

7. Vorrichtung nach einem der Ansprüche 1 bis 6, dadurch gekennzeichnet, daß die elektrischen Verbindungen zwischen den Analog- Anschlüssen (6) und dem Analog-Leitungsbündel (2) sowie zwischen den Digital-Anschlüssen (7) und dem Digital-Leitungsbündel (3) mechanisch lösbar sind.

8. Vorrichtung nach Anspruch 7, dadurch gekennzeichnet, daß die Analog-Anschlüsse (6) und die Digital-Anschlüsse (7) als auf den Leiterplatten (1) befestigte Steckkontakte ausgebildet sind und das Analog-Leitungsbündel (2) und das Digital-Leitungsbündel (3) mit dazu passenden Steckerleisten (20) versehen sind.

9. Vorrichtung nach Anspruch 8, dadurch gekennzeichnet, daß die Steckerleisten (20) an der Rückseite des Gehäuses bzw. auf einer Basis-Leiterplatte (19) paarweise so angebracht sind, daß die Leiter-

platten (1) mit ihren Steckkontakten in die Steckerleisten (20) eingesteckt werden können.

10. Vorrichtung nach Anspruch 9, *dadurch gekennzeichnet,* daß die Steckerleisten (20) an der Rückseite des Gehäuses bzw. auf der Basis-Leiterplatte (19) paarweise vertikal übereinander angebracht sind.

Fig.1

Fig. 2